# EUROPEAN PATENT APPLICATION

(11) **EP 3 086 371 A1**
(43) Date of publication of application: **26.10.2016**
(21) Application number: 15196943.3
(22) Date of filing: 30.11.2015
(51) Int. Cl.: H01L 27/15, H01L 33/38, H01L 33/50, H01L 33/54

(54) **LIGHT EMITTING MODULE**

(30) Priority: 20.04.2015 TW 104112567
(71) Applicant: Everlight Electronics Co., Ltd, New Taipei City 23860 (TW)
(72) Inventor: LIEN, Ya-Huei, 23860 New Taipei City (TW); CHANG, Chung-kai, 23860 New Taipei City (TW)
(74) Representative: Becker Kurig Straus

(57) **Abstract**

A light emitting module including an electrode substrate and a plurality of light emitting diodes is provided. The electrode substrate includes a first joint portion and an opposite second joint portion that are located at opposite ends of the electrode substrate respectively. The first joint portion includes a first through hole or a first notch. The plurality of light emitting diodes is disposed on a carrying surface of the electrode substrate, wherein the plurality of light emitting diodes is arranged along a long side direction of the electrode substrate, and is electrically coupled with the electrode substrate.

## Description

This application claims priority to Taiwan Patent Application No. 104112567 filed on April 20th, 2015.

### CROSS-REFERENCES TO RELATED APPLICATIONS

Not applicable.

### BACKGROUND OF THE INVENTION

### Field of the Invention

The present invention relates to a light emitting module.

### Descriptions of the Related Art

Owing to rapid development of the semiconductor technologies, currently light-emitting diodes (LEDs) can provide a high luminance output and be used in various light mixing applications. The LEDs operate in the following way: by applying a current to a compound semiconductor, electrons and holes are recombined so that energy is released in the form of light. Because the LEDs emit light not through heating or discharging, the LEDs have a long lifetime of more than one hundred thousands of hours. Moreover, as compared with the conventional incandescent light sources, the LEDs further have such advantages as power saving, a small volume, and a short response time, so they have been widely used in displays and lighting applications.

As the whole lighting market evolves from the conventional lighting towards LED lighting, LED filaments in the form of conventional incandescent lamps to which people are familiar and having the advantages of LEDs have received much attention in recent years. In order for the LED filaments to present good light emission uniformity at various angles, most of the LED filaments use nonconductive transparent substrates to carry the LEDs and have the LEDs connected to electrodes through spot soldering and external metal leads. However, this makes the manufacturing process complex, and the spot soldering presents a risk of loose of the soldered point, which leads to a poor reliability.

### SUMMARY OF THE INVENTION

The present invention provides a light emitting module which makes the substrate connecting process simple and the connection reliable.

The present invention provides a light emitting mode which presents good light emission uniformity.

An embodiment of the present invention discloses a light emitting module, which comprises an electrode substrate and a plurality of light emitting diodes (LEDs). The electrode substrate comprises a first joint portion and an opposite second joint portion that are located at two opposite ends of the electrode substrate respectively, and the first joint portion comprises a first through hole or a first notch. The plurality of LEDs is disposed on a carrying surface of the electrode substrate, wherein the LEDs are arranged along a long side direction of the electrode substrate and are electrically coupled with the electrode substrate.

In an embodiment of the present invention, the electrode substrate comprises a first electrode board, a second electrode board and an insulative connecting portion for connecting the first electrode board and the second electrode board, the LEDs are disposed on the second electrode board, and each of the LEDs has one end thereof electrically connected to the first electrode board and the other end thereof electrically connected to the second electrode board.

In an embodiment of the present invention, the light emitting module further comprises a fluorescent encapsulant that covers the electrode substrate and the LEDs.

In an embodiment of the present invention, the LED is HV LED, DC LED or AC LED.

In an embodiment of the present invention, the electrode substrate comprises apertures for light transmission.

In an embodiment of the present invention, the fluorescent encapsulant covers the electrode substrate and the LEDs in an encapsulant form in a surface direction orthogonal to the long side direction of the electrode substrate, and the fluorescent encapsulant extends to cover the electrode substrate and the LEDs in the encapsulant form along the long side direction of the electrode substrate and encapsulates the LEDs into the fluorescent encapsulant.

In an embodiment of the present invention, the fluorescent encapsulant has a first surface and a second surface opposite to each other, the LEDs and the electrode substrate are located between the first surface and the second surface, the carrying surface faces towards the first surface, a maximum distance between the carrying surface and the first surface in a direction perpendicular to the carrying surface is an upper encapsulant thickness, and a maximum distance between the other surface of the electrode substrate that is opposite to the carrying surface and the second surface in the direction perpendicular to the carrying surface is a lower encapsulant thickness, and the upper encapsulant thickness is greater than the lower encapsulant thickness.

In an embodiment of the present invention, the first surface is a curved convex surface and the second surface is a curved convex surface.

In an embodiment of the present invention, the first surface is a curved convex surface and the second surface is a planar surface.

In an embodiment of the present invention, the second joint portion comprises a second through hole or a second notch.

An embodiment of the present invention discloses a light emitting module, which comprises an electrode substrate, a plurality of LEDs and a fluorescent encapsulant. The LEDs are disposed on a carrying surface of the electrode substrate, wherein the LEDs are arranged along a long side direction of the electrode substrate and electrically coupled with the electrode substrate. The fluorescent encapsulant covers the electrode substrate and the LEDs, and has a first surface and a second surface opposite to each other. The LEDs and the electrode substrate are located between the first surface and the second surface. The carrying surface faces towards the first surface, a maximum distance between the carrying surface and the first surface in a direction perpendicular to the carrying surface is an upper encapsulant thickness, and a maximum distance between the other surface of the electrode substrate that is opposite to the carrying surface and the second surface in the direction perpendicular to the carrying surface is a lower encapsulant thickness, and the upper encapsulant thickness is greater than the lower encapsulant thickness.

As can be known from the above descriptions, in the light emitting module according to one of the embodiments of the present invention, the electrode substrate comprises a first joint portion and an opposite second joint portion which are located at two opposite ends of the electrode substrate respectively, and the first joint portion comprises a first through hole or a first notch. By applying present invention, the substrate connecting process is made simple and reliable because metal wires may be connected not through spot soldering which presents a risk of loose of the soldered point and thus leads to a poor reliability. In the light emitting module according to another embodiment of the present invention, the electrode substrate and the LEDs are covered by the fluorescent encapsulant and the upper encapsulant thickness is greater than the lower encapsulant thickness, so the light emitting module presents good light emission uniformity.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG 1A** is a schematic top view of a light emitting module according to an embodiment of the present invention.
**FIG. 1B** is a schematic top view of a light emitting module according to another embodiment of the present invention.
**FIG 1C** is a schematic cross-sectional view of the light emitting module shown in **FIG. 1A**.
**FIG 2A** is a graph of illuminance versus positions (angles) of the light emitting module shown in **FIG 1A**.
**FIG. 2B** is a graph of color temperature versus positions (angles) of the light emitting module shown in **FIG 1A**.
**FIG 3A** is a schematic cross-sectional view of a light emitting module according to a further embodiment of the present invention.
**FIG 3B** is a schematic cross-sectional view of a light emitting module according to yet a further embodiment of the present invention.
**FIG 3C** is a graph of illuminance versus positions (angles) of the light emitting module shown in **FIG 3A**.
**FIG 3D** is a graph of color temperature versus positions (angles) of the light emitting module shown in **FIG 3A**.
**FIG 4** is a schematic cross-sectional view of a light emitting module according to yet another embodiment of the present invention.

### DESCRIPTION OF THE PREFERRED EMBODIMENT

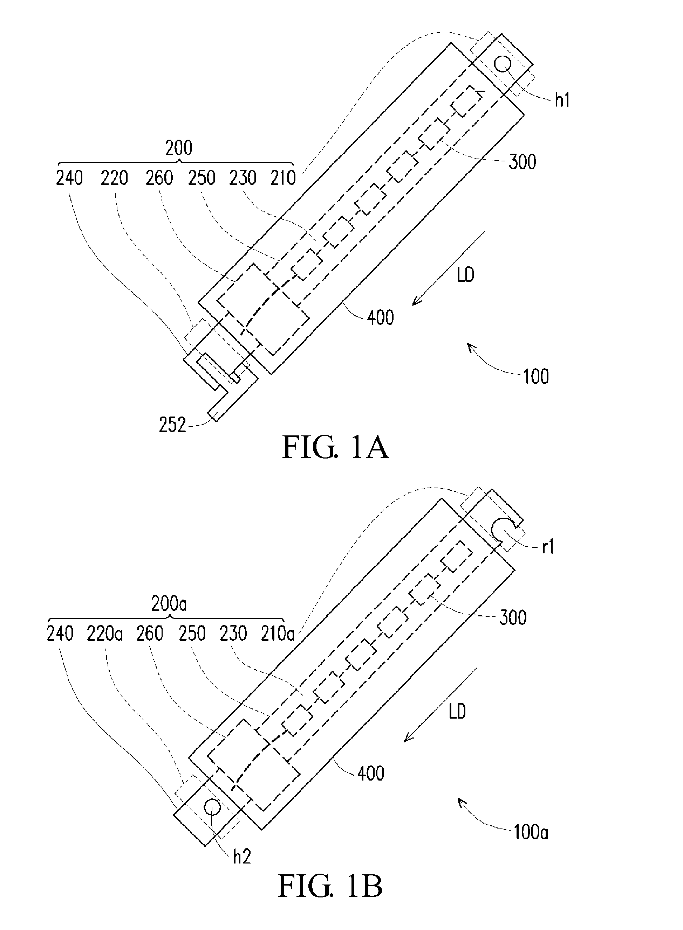

**FIG 1A** is a schematic top view of a light emitting module according to an embodiment of the present invention. Referring to **FIG 1A****,** the light emitting module **100** in this embodiment comprises an electrode substrate **200** and a plurality of light-emitting diodes (LEDs) **300.** The LEDs 300 can be, for example, HV-LED, DC-LED, OLED, III-V compound LED, LD, photonic Crystal LED, Hybrid LED, Nanorod LED, HP LED, or AC-LED. The LED die can be electrically connected via wire bonding, tape automated bonding or flip chip bonding. The LED die can be packaged as SMD type, DIP type, high power type, piranha type or without any package. The present invention is not limited thereto. The electrode substrate **200** comprises a first joint portion **210** and an opposite second joint portion **220** which are located at two opposite ends of the electrode substrate **200** respectively. The electrode substrate **200** is an electrically conductive substrate. The electrode substrate **200** is, for example, a metal electrode substrate, or a circuit substrate having conductive wirings such as a printed circuit board (PCB), a metal core printed circuit board (MCPCB) or a multi-layer printed circuit board (MPCB), but the present invention is not limited thereto. Additionally, the LEDs **300** are disposed on a carrying surface **230** of the electrode substrate **200.** The LEDs **300** are arranged along a long side direction **LD** of the electrode substrate **200** in series with or in parallel to each other, and are electrically coupled with the electrode substrate **200.** In particular, if the electrode substrate **200** is, for example but not limited to, a metal electrode substrate, the electrode substrate **200** may further comprise a first electrode board **240**, a second electrode board **250** and an electrically insulative connecting portion **260** for connecting the first electrode board **240** and the second electrode board **250.** The LEDs **300** are disposed on the second electrode board **250**, and the second electrode board **250** can comprise apertures (not shown) for the light to pass through the electrode board. Each of the LEDs **300** has one end electrically connected to the first electrode board **240** and the other end electrically connected to the second electrode board **250.** In this embodiment, because the first electrode board **240** and the second electrode board **250** are separated from each other by the insulative connecting portion **260**, the anode and the cathode of each of the LEDs **300** will not be short-circuited. Additionally, the insulative connecting portion **260** may be a plastic casing having an insulative property or be some other member adapted to join a plurality of conductive objects together but insulate these conductive objects from each other, but the present invention is not limited thereto. In other embodiments, if the electrode substrate **200** is, for example but not limited to, a circuit substrate having conductive wirings, the electrode substrate **200** may further comprise a plurality of circuit wirings so that the LEDs **300** are disposed on the electrode substrate **200**, e.g., in series with more than one HV LEDs and more than one LV LEDs or in parallel to each other.

In particular, the electrode substrate **200** of the light emitting module **100** may be of a strip type, and a shape of the electrode substrate **200** may be similar to that of a filament structure of a conventional incandescent lamp so that the light emitting module **100** may be installed inside a casing of the conventional incandescent lamp to simulate an incandescent lamp filament. Additionally, the electrode substrate **200** of the light emitting module **100** may also be of other forms (e.g., a spiral form, a U-shaped form or a W-shaped form), and the LEDs **300** may also be arranged in different ways on the electrode substrate **200** along the long side direction **LD**, and the present invention is not limited thereto.

Referring still to **FIG. 1A**, in this embodiment, the first joint portion **210** of the electrode substrate **200** comprises a first through hole **h1** adapted to allow a wire to pass therethrough or to be supported therein. The second joint portion **220** may further be fixed and connected by using wires of a clamp **252** to clamp the second joint portion **220**, but the present invention is not limited thereto. In other words, the second joint portion **220** may also comprise a through hole or a notch structure. The clamp **252** may be a clamping member made of a metal material, or may be some other clamping member having a conductive property. In particular, the light emitting module **100** of this embodiment has the LEDs **300** supported on the electrode substrate **200** but not on a nonconductive transparent substrate. The LEDs 300 can be, for example, HV-LED, DC-LED, OLED, III-V compound LED, LD, photonic Crystal LED, Hybrid LED, Nanorod LED, HP LED, or AC-LED. The LED die can be electrically connected via wire bonding, tape automated bonding or flip chip bonding. The LED die can be packaged as SMD type, DIP type, high power type, piranha type or without any package. The present invention is not limited thereto. When one end of the LEDs **300** connected in series or in parallel are to be connected with a metal wire, it is unnecessary to spot solder the one end of the LEDs to the external metal wire via a metal electrode lead. Instead, the LEDs **300** can be electrically connected to the second electrode board **250** directly and then, via the second electrode board **250**, connected to the metal wire passing through or coiled around and tied to the first through hole **h1**. Additionally, the second electrode board **250** can further comprise apertures (not shown) for the light to pass through the electrode board. Accordingly, the light emitting module **100** of this embodiment has an effect of more reliable connection and can prevent the risk of loose of the soldered point. However, the present invention is not limited thereto, and in other words, spot soldering may be further performed after the metal wire passes through or is coiled around and tied to the first through hole **h1.** Additionally, as compared with a light emitting module that uses a nonconductive transparent substrate, the light emitting module **100** of this embodiment can be electrically connected to an external metal wire without the need of additional metal electrode leads, and this makes the manufacturing process of the light emitting module **100** simpler. The position and the shape of the first through hole **h1** of the embodiment of the present invention are not limited to what depicted in **FIG 1A**, and the first through hole **h1** may also be disposed in the second joint portion **220.**

**FIG 1B** is a schematic top view of a light emitting module according to another embodiment of the present invention. Referring to **FIG 1B**, the light emitting module **100a** in this embodiment is similar to the light emitting module **100** shown in **FIG 1A**; and for similar members and related functions, reference may be made to descriptions of the light emitting module **100** and no further description will be made herein. The light emitting module **100a** differs from the light emitting module **100** mainly in that, the electrode substrate **200a** of the light emitting module **100a** comprises a first joint portion **210a** and a second joint portion **220a** which are located at two opposite ends of the electrode substrate **200a** respectively. The first joint portion **210a** comprises a first notch **r1** and the second joint portion **220a** comprises a second through hole **h2**; however, the present invention is not limited thereto, and in other embodiments, the first notch **r1** and the second through hole **h2** may be swapped in position, or the two opposite ends of the electrode substrate **200a** both have a first notch **r1** or both have a second through hole **h2.** In this embodiment, the function of the first notch **r1** is similar to that of the first through hole **h1**, and the first notch **r1** is adapted to allow a wire to pass therethrough or to be supported therein. For example, the metal wire is fixed to the first notch **r1** by passing therethrough or being coiled around and tied to the first notch **r1** so that the electrode substrate **200a** is reliably connected to the metal wire. In this way, the LEDs **300** can be electrically connected to the second electrode board **250** directly and then, via the second electrode board **250**, is connected to the metal wire passing through or coiled around and tied to the first notch **r1.** Additionally, spot soldering may be further performed after the metal wire passes through or coiled around and tied to the first notch **r1.**

In particular, the first notch **r1** may be located at any position on the second joint portion **220a** of the first electrode board **240** or the first joint portion **210a** of the second electrode board **250**, and the position and the shape of the first notch **r1** in the embodiment of the present invention are not limited to what shown in **FIG 1B****.**

Additionally, the second electrode board **250** can further comprise apertures (not shown) for the light to pass through the electrode board.

Besides, in this embodiment, the second joint portion **220a** comprises a second through hole **h2.** The second through hole **h2** is similar to the first through hole **h1** in function, and is also adapted to allow a wire to pass therethrough or to be supported therein so that the light emitting module **100a** can be connected to an external metal wire directly via the second through hole **h2** of the first electrode board **240** by passing the metal wire through (or coiling the metal wire around and tying the metal wire to) the second through hole **h2.** In particular, the second joint portion **220a** may also comprise a second notch similar to the first notch **r1.** For the related function of the second notch, reference may be made to the description of the first notch **r1** and no further description will be made herein. The numbers of the first through hole **h1**, the second through hole **h2** or the first notch **r1** in the embodiment of the present invention are not limited to what shown in **FIG 1A** and **FIG 1B**, and in other embodiments, a plurality of through holes or notches, or at least one through hole in combination with at least one notch may be disposed on the first joint portion **210** (**210a**), on the second joint portion **220** (**220a**), or on the first and the second joint portions of the light emitting module **100** (**100a**).

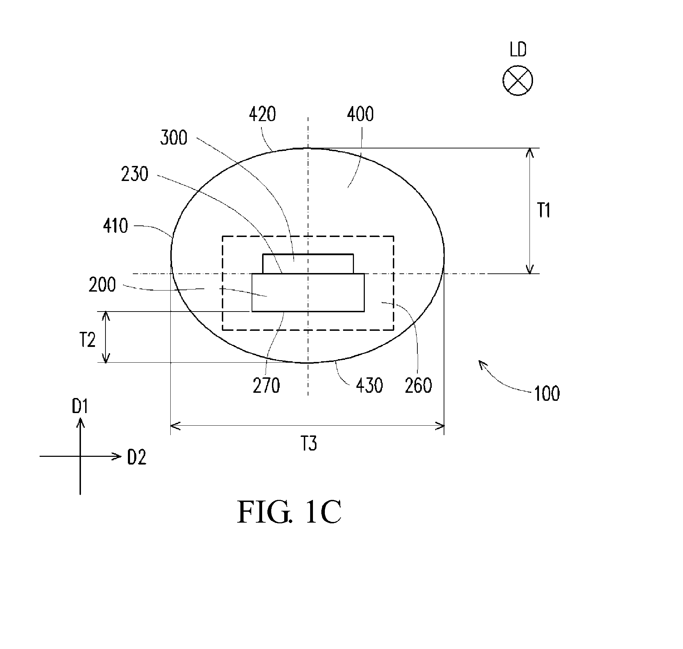

**FIG 1C** is a schematic cross-sectional view of the light emitting module shown in **FIG. 1A****.** Referring to **FIG 1C** together with **FIG 1A**, the light emitting module **100** in this embodiment further comprises a fluorescent encapsulant **400** covering the electrode substrate **200** and the LEDs **300.** The fluorescent encapsulant **400** covers the electrode substrate **200** and the LEDs **300** in an encapsulant form **410** in a surface direction orthogonal to the long side direction **LD** of the electrode substrate **200**, and the fluorescent encapsulant **400** extends to cover the electrode substrate **200** and the LEDs **300** in the encapsulant form **410** along the long side direction **LD** of the electrode substrate **200** and encapsulates the LEDs **300** into the fluorescent encapsulant **400.** In this embodiment, the fluorescent encapsulant **400** further covers the insulative connecting portion **260** in the encapsulant form **410** so that both the LEDs **300** and the insulative connecting portion **260** are located within the fluorescent encapsulant **400.**

In particular, the fluorescent encapsulant **400** is adapted to absorb light of a first wavelength, convert the light of the first wavelength into light of a second wavelength and emit the light of the second wavelength, where the second wavelength is greater than the first wavelength. In this embodiment, the fluorescent encapsulant **400** may be an adhesive containing phosphor, e.g., an adhesive containing yttrium aluminum garnet phosphor (YAG phosphor). The fluorescent encapsulant **400** is adapted to convert a part (e.g., blue light) of the light having the first wavelength into light of the greater second wavelength (i.e., yellow light). However, the present invention is not limited thereto, and the fluorescent encapsulant **400** may also be an adhesive containing other species of phosphors and be adapted to convert light bands corresponding to the phosphors contained therein; and also, the conversion is not limited to conversion from a shorter wavelength into a greater (longer) wavelength, but may also be a conversion from a longer wavelength into a shorter wavelength. The LEDs **300** may be LEDs of different colors, e.g., red, green or other colors of LEDs, and the light emitting module **100** may also comprise LEDs **300** of different colors. Additionally, the fluorescent encapsulant **400** covering the LEDs **300** acts not only as a material for converting the wavelength of the light emitted from the LEDs 300, but also as a material for protecting the LEDs **300** and wirings thereof. In particular, the fluorescent encapsulant **400** covers not only the LEDs **300**, but also wirings for connecting the LEDs **300** in series, wirings for connecting the LEDs **300** to the first electrode board **240** and wirings for connecting the LEDs **300** to the second electrode board **250.** As being protected by the fluorescent encapsulant **400**, the LEDs **300** and the aforesaid wirings are less liable to damage.Referring still to **FIG 1C**, the fluorescent encapsulant **400** in this embodiment has a first surface **420** and a second surface **430** opposite to each other. The first surface **420** is a curved convex surface and the second surface **420** is a curved convex surface, and the LEDs **300** and the electrode substrate **200** are located between the first surface **420** and the second surface **430.** The carrying surface **230** of the electrode substrate **200** faces towards the first surface **420.** Additionally, a maximum distance between the carrying surface **230** and the first surface **420** in a direction **D1** perpendicular to the carrying surface **230** is an upper encapsulant thickness **T1**. A maximum distance between the other surface **270** of the electrode substrate **200** that is opposite to the carrying surface **230** and the second surface **430** in the direction **D1** perpendicular to the carrying surface **230** is a lower encapsulant thickness **T2.** Furthermore, a maximum distance of the fluorescent encapsulant **400** in a direction orthogonal (or perpendicular) to the direction **D1** is a side encapsulant thickness **T3.**

In this embodiment, because the fluorescent encapsulant **400** covers the electrode substrate **200** and the LEDs **300** and encapsulates the LEDs **300** into the fluorescent encapsulant **400**, at least a part of the light emitted by the LEDs **300** in the direction **D1** can be reflected or scattered by the phosphor in the fluorescent encapsulant **400** to exit from the first surface **420** and/or the second surface **430** of the fluorescent encapsulant **400.** More specifically, because the LEDs **300** are located within the fluorescent encapsulant **400** in the light emitting module **100** of this embodiment, a part of the light emitted by the LEDs **300** in the direction **D1** can still exit from the second surface **430** of the fluorescent encapsulant **400** through being reflected and/or scattered by the phosphor even though the LEDs **300** are carried by the opaque electrode substrate **200** in the light emitting module **100** of this embodiment. Therefore, the light emitting module **100** of this embodiment can provide an effect of emitting light in various directions (at various angles) from the first surface **420** and the second surface **430**, i.e., can emit light within a large range.

Additionally, the electrode substrate 200 can further comprise apertures (not shown) for the light to pass through the electrode board.

In this embodiment, the upper encapsulant thickness **T1** of the fluorescent encapsulant **400** is greater than the lower encapsulant thickness **T2.** In particular, a ratio of the lower encapsulant thickness **T2** to the upper encapsulant thickness **T1** may range between 0.22 and 0.43 in this embodiment. Preferably, the ratio of the lower encapsulant thickness to the upper encapsulant thickness ranges between 0.25 and 0.30. For example, the upper encapsulant thickness **T1** of the light emitting module **100** may be 1.56 millimeter (mm), the lower encapsulant thickness **T2** may be 0.45 mm, and the side encapsulant thickness **T3** may be 1.86 mm. Because the LEDs **300** are carried by the opaque electrode substrate **200** in the light emitting module **100** of this embodiment, the light exiting in various directions (at various angles) from the second surface **430** must be obtained by using the phosphor in the fluorescent encapsulant **400** to reflect and/or scatter a part of the light having the first wavelength (e.g., the blue light wavelength) emitted by the LEDs **300** in the direction **D1.** Therefore, as compared with the light exiting from the first surface **420**, the light exiting from the second surface **430** is more likely to travel a longer distance and, thus, is more likely to excite the phosphor in the fluorescent encapsulant **400** so as to be converted into light of a second wavelength (e.g., the yellow light wavelength), which makes the color temperature of the light exiting from the second surface **430** higher. In this embodiment, because the upper encapsulant thickness **T1** of fluorescent encapsulant **400** is greater than the lower encapsulant thickness **T2** in the light emitting module **100** of this embodiment, the path length of the light exiting from the first surface **420** and the path length of the light exiting from the second surface **430** become close to each other and, therefore, the color temperatures thereof become close to each other. In this way, the light emitting module **100** of this embodiment presents a relatively uniform correlated color temperature (CCT) at various angles.

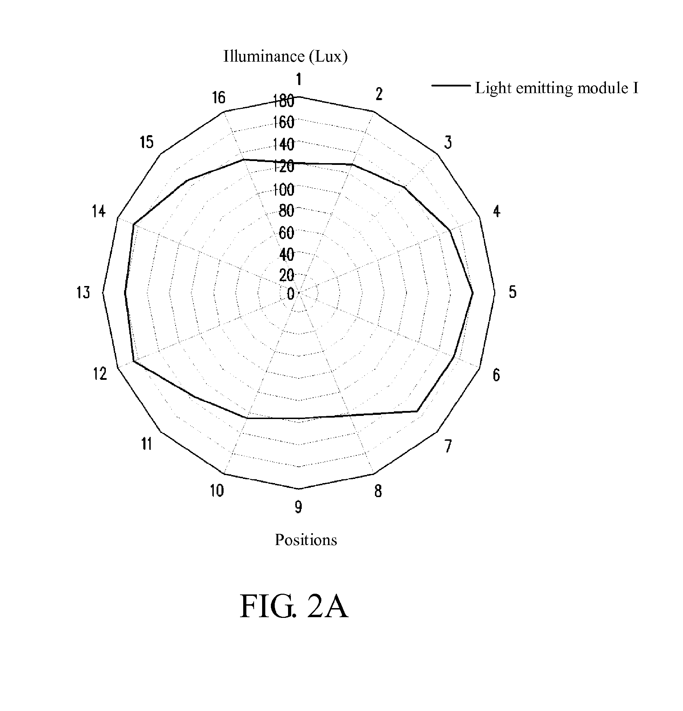

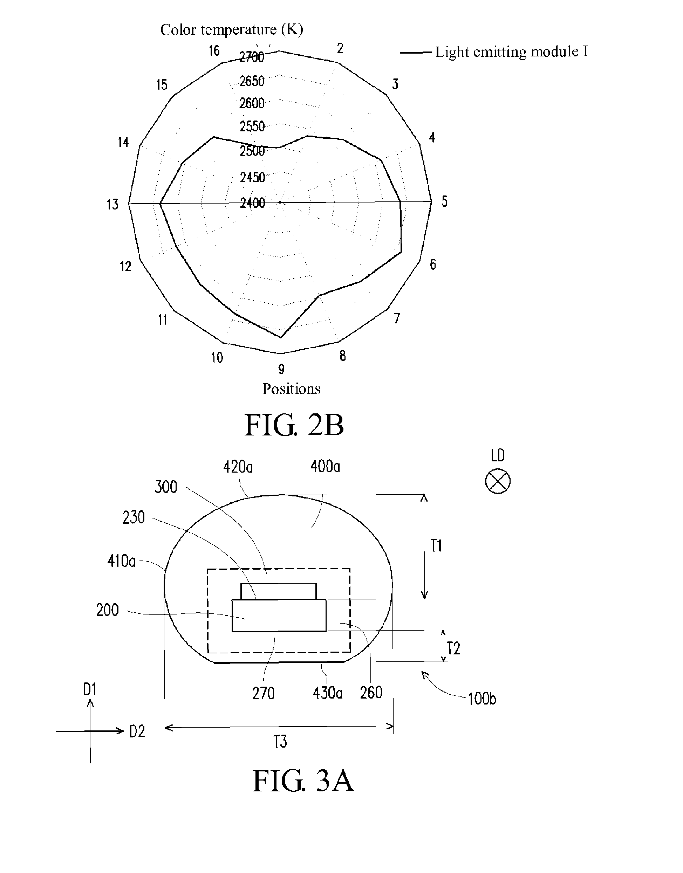

**FIG 2A** is a graph of illuminance versus positions (angles) of the light emitting module shown in **FIG 1C****.** **FIG 2B** is a graph of color temperature versus positions (angles) of the light emitting module shown in **FIG 1C****.** Please refer to **FIG 1A****,** **FIG 1C**, **FIG 2A** and **FIG 2B** together. In **FIG 2A** and **FIG 2B**, the light emitting module I represents the light emitting module **100.** Positions 1-16 represents sixteen measured points that are equidistant from the light emitting module **100** in a plane that passes through a center point of the light emitting module **100** in the long side direction **LD** and that takes the long side direction **LD** as an axis. In particular, every two adjacent positions include an angle of 22.5° with respect to the light emitting module **100**, so the arrangement of the measurement positions 1∼16 is equivalent to an arrangement in which one measurement point is disposed every 22.5° and the measurement is made for a whole cycle of 360°. Here, a direction from the light emitting module **100** to the position 1 coincides with the direction **D1**, while a direction from the light emitting module **100** to the position 9 is opposite to the direction **D1**.

In this embodiment, according to the illuminance graph of **FIG. 2A**, the light emitting module **100** can provide an effect of uniformly exiting light in various directions (at various angles) from the first surface **420** and the second surface **430** because the LEDs **300** are located within the fluorescent encapsulant **400.** Therefore, the illuminance values of the light emitting module **100** measured at various angles (positions 1∼16) are very uniform, and the overall light distribution profile is very uniform. Among others, the illuminance value at the 180° angle (position 9) is very close to that at the 0° angle (position 1).

Also in this embodiment, according to the color temperature graph of **FIG 2B**, because the upper encapsulant thickness **T1** of the fluorescent encapsulant 400 is greater than the lower encapsulant thickness **T2** in the light emitting module **100** of this embodiment, the path length of the light exiting from the first surface **420** and the path length of the light exiting from the second surface **430** become relatively close to each other. Therefore, there is no great difference between the color temperature values measured at the various angles (positions 1∼16). As compared with the light exiting from the first surface **420**, still a large proportion of the light exiting from the second surface **430** is converted by the phosphor, so the color temperature value in the 180° (position 9) direction is slightly higher than that at the 0° (position 1) direction. However, generally speaking, the color temperature values of the light emitting module **100** measured at the various angles (positions 1∼16) mostly fall into the range of 2500K to 2650K.

**FIG. 3A** is a schematic cross-sectional view of a light emitting module according to a further embodiment of the present invention. Referring to **FIG 3A**, the light emitting module **100b** in this embodiment is substantially identical to the light emitting module **100** of **FIG 1C**, so for the similar members and related functions, reference may be made to the description of the light emitting module **100** and no further description will be made herein. The light emitting module **100b** differs from the light emitting module **100** mainly in that, the first surface **420a** of the fluorescent encapsulant **400a** is a curved convex surface and the second surface **430a** is a planar or approximately planar surface in the light emitting module **100b.** In particular, at least a part of the backed encapsulant of the light emitting module **100b** is removed (or the fluorescent encapsulant **400a** at the second surface **430a** side is formed to be relatively thin, or substantially no fluorescent encapsulant **400a** is formed on the second surface **430a** side, or substantially no fluorescent encapsulant **400a** is formed on the other surface **270** side of the electrode substrate **200**), and the upper encapsulant thickness **T1**, the lower encapsulant thickness **T2** and the side encapsulant thickness **T3** of the light emitting module **100b** are appropriately adjusted. Also in this embodiment, it may be unnecessary to completely cover the insulative connecting portion **260** with the fluorescent encapsulant **400a,** that is, it may be that a part of the insulative connecting portion **260** is located within the fluorescent encapsulant **400a** and the rest of the insulative connecting portion **260** is exposed to the service environment of the light emitting module **100b.**

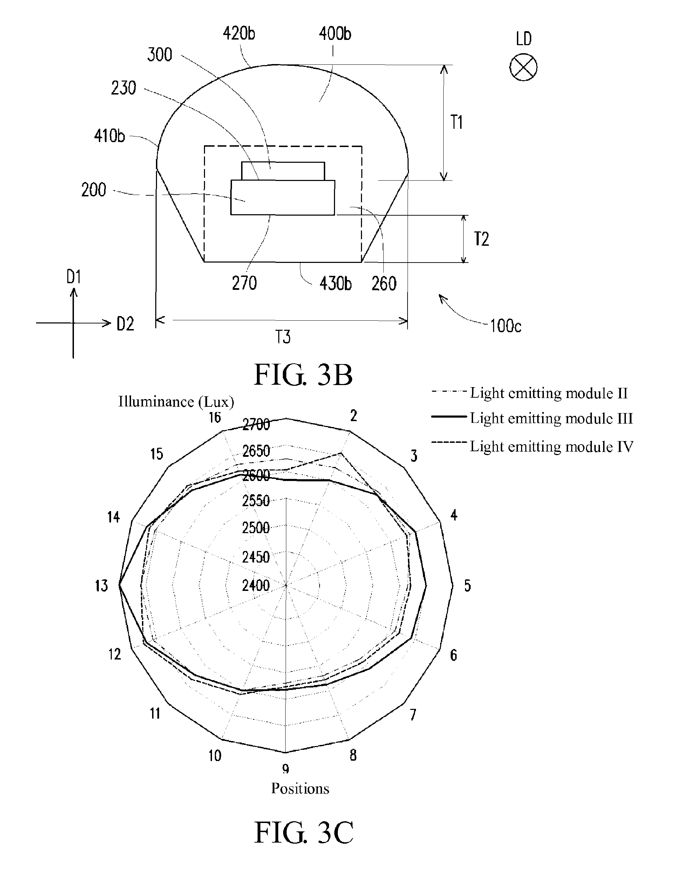

**FIG 3B** is a schematic cross-sectional view of a light emitting module according to yet a further embodiment of the present invention. Referring to **FIG 3B**, the light emitting module **100c** in this embodiment is substantially identical to the light emitting module **100b** of **FIG. 3A**, so for the similar members and related functions, reference may be made to the description of the light emitting module **100b** and no further description will be made herein. In particular, the first surface **420b** of the fluorescent encapsulant **100c** is a curved convex surface and the second surface **430b** is a planar or approximately planar surface in the light emitting module **100c.** Furthermore, not only at least a part of the backed encapsulant of the light emitting module **100c** is removed (or the fluorescent encapsulant **400b** at the second surface **430b** side is formed to be relatively thin, or substantially no fluorescent encapsulant **400b** is formed on the second surface **430b** side, or substantially no fluorescent encapsulant **400b** is formed on the other surface **270** side of the electrode substrate **200**), but a part of the side encpasulant is also removed or formed directly into the side encapsulant form and thickness shown in the embodiment of **FIG 3B****.** Besides, the upper encapsulant thickness **T1**, the lower encapsulant thickness **T2** and the side encapsulant thickness **T3** of the light emitting module **100b** are appropriately adjusted. In this embodiment, both the LEDs **300** and the insulative connecting portion **260** are located within the fluorescent encapsulant **400b.**

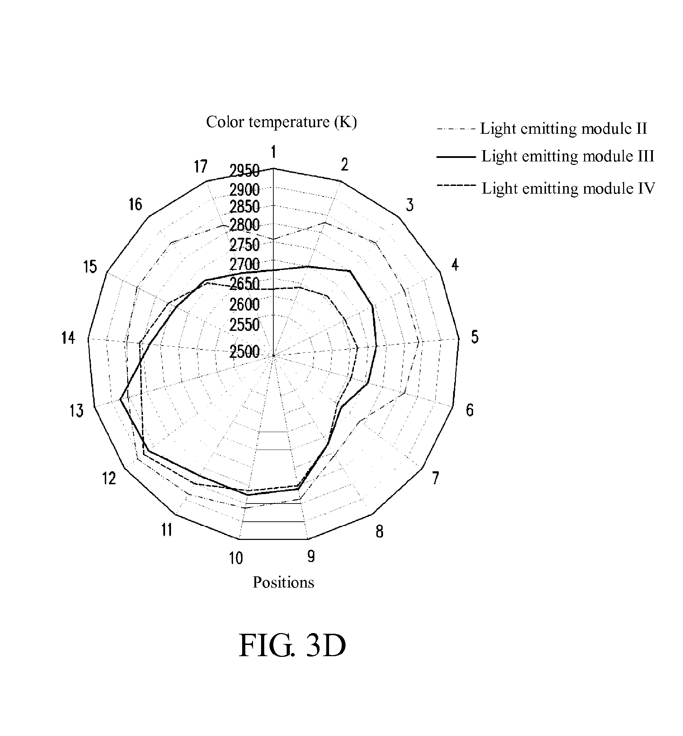

**FIG 3C** is a graph of illuminance versus positions (angles) of the light emitting module shown in **FIG 3A**. **FIG 3D** is a graph of color temperature versus positions (angles) of the light emitting module shown in **FIG 3A**. Please refer to **FIG 3A**, **FIG 3C** and **FIG 3D** together. In **FIG 3C** and **FIG 3D**, the light emitting module II represents the light emitting module **100b**, in which the upper encapsulant thickness **T1** of the fluorescent encapsulant **400a** is 1.2 mm, the lower encapsulant thickness **T2** is 0.3 mm and the side encapsulant thickness **T3** is 1.55 mm. The light emitting module III represents the light emitting module **100b**, in which the upper encapsulant thickness **T1** of the fluorescent encapsulant **400a** is 1.3 mm, the lower encapsulant thickness **T2** is 0.3 mm and the side encapsulant thickness **T3** is 1.55 mm. The light emitting module IV represents the light emitting module **100b**, in which the upper encapsulant thickness **T1** of the fluorescent encapsulant **400a** is 1.3 mm, the lower encapsulant thickness **T2** is 0.3 mm and the side encapsulant thickness T3 is 1.65 mm. Arrangement of the positions 1∼16 are just identical to that of **FIG 2A** and **FIG 2B**, and reference may be made to the description of the positions 1∼16 of **FIG 2A** and **FIG 2B**, so no further description will be made herein.

According to the illuminance graph of **FIG 3C**, the light emitting module **300** can provide an effect of uniformly exiting light in various directions (at various angles) from the first surface **420a** and the second surface **430a** because the LEDs **300** are located within the fluorescent encapsulant **400a.** Therefore, the illuminance values of the light emitting modules II, III and IV measured at various angles (positions 1∼16) are very uniform. In this embodiment, the overall light distribution profiles of the three light emitting modules are all very uniform.

According to the color temperature graph of **FIG 3D**, because as compared with the light exiting from the first surface **420a**, still a large proportion of the light exiting from the second surface **430a** is converted by the phosphor, the color temperature values of the light emitting modules II, III and IV in the 180° (position 9) direction are slightly higher than those at the 0° (position 1) direction. Generally speaking, the color temperature values of the light emitting module II measured at the various angles (positions 1∼17) mostly fall into the range of 2750K to 2900K, the color temperature values of the light emitting module III measured at the various angles (positions 1∼17) mostly fall into the range of 2700K to 2900K, and the color temperature values of the light emitting module IV measured at the various angles (positions 1∼16) mostly fall into the range of 2650K to 2900K. In this embodiment, the color temperature uniformity of all the light emitting modules II, III and IV fall within the allowable range.

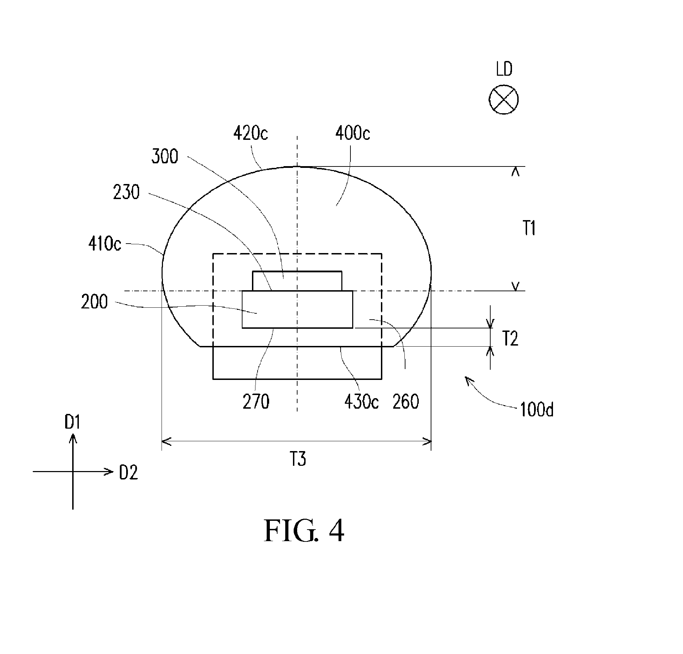

**FIG 4** is a schematic cross-sectional view of a light emitting module according to yet another embodiment of the present invention. Referring to **FIG 4**, the light emitting module 100d in this embodiment is substantially identical to the light emitting module **100c** of **FIG 3B**, so for the similar members and related functions, reference may be made to the description of the light emitting module **100c** and no further description will be made herein. In particular, the fluorescent encapsulant **400c** is formed to be relatively thin on the second surface **430c** side of the light emitting module **100d** (or substantially no fluorescent encapsulant **400c** is formed on the second surface **430c** side, or substantially no fluorescent encapsulant **400c** is formed on the other surface **270** side of the electrode substrate **200**), so at least a part of the insulative connecting portion **260** is not coated by the fluorescent encapsulant **400c.** Besides, in this embodiment, a ratio of the lower encapsulant thickness **T2** to the upper encapsulant thickness **T1** may be greater than 0 but no greater than 0.25.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A light emitting module, comprising:
an electrode substrate (200), comprising a first joint portion (210) and an opposite second joint portion (220) that are located at two opposite ends of the electrode substrate (200) respectively, the first joint portion (210) comprising a first through hole or a first notch; and
a plurality of light emitting diodes ,LEDs, disposed on a carrying surface of the electrode substrate (200), wherein the LEDs are arranged along a long side direction of the electrode substrate (200) and are electrically coupled with the electrode substrate (200).

2. The light emitting module of claim 1, wherein the electrode substrate (200) comprises a first electrode board (240), a second electrode board (250) and an insulative connecting portion (260) for connecting the first electrode board (240) and the second electrode board (250), the LEDs are disposed on the second electrode board (250), and each of the LEDs has one end thereof electrically connected to the first electrode board (240) and the other end thereof electrically connected to the second electrode board (250).

3. The light emitting module of any one of the preceding claims, further comprising a fluorescent encapsulant (400) that covers the electrode substrate (200) and the LEDs.

4. The light emitting module of any one of the preceding claims, wherein the electrode substrate (200) comprises apertures for light transmission.

5. The light emitting module of any one of claims 3 and 4, wherein the fluorescent encapsulant (400) has a first surface and a second surface opposite to each other, the LEDs and the electrode substrate (200) are located between the first surface and the second surface, the carrying surface faces towards the first surface, a maximum distance between the carrying surface and the first surface in a direction perpendicular to the carrying surface is an upper encapsulant thickness, and a maximum distance between the other surface of the electrode substrate (200) that is opposite to the carrying surface and the second surface in the direction perpendicular to the carrying surface is a lower encapsulant thickness, and the upper encapsulant thickness is greater than the lower encapsulant thickness.

6. The light emitting module of any one of the preceding claims, wherein the second joint portion (220) comprises a second through hole or a second notch.

7. A light emitting module, comprising:
an electrode substrate (200);
a plurality of LEDs disposed on a carrying surface of the electrode substrate (200), wherein the LEDs are arranged along a long side direction of the electrode substrate (200) and electrically coupled with the electrode substrate (200); and
a fluorescent encapsulant (400) covering the electrode substrate (200) and the LEDs, wherein the fluorescent encapsulant (400) has a first surface and a second surface opposite to each other, the LEDs and the electrode substrate (200) are located between the first surface and the second surface, the carrying surface faces towards the first surface, a maximum distance between the carrying surface and the first surface in a direction perpendicular to the carrying surface is an upper encapsulant thickness, and a maximum distance between the other surface of the electrode substrate (200) that is opposite to the carrying surface and the second surface in the direction perpendicular to the carrying surface is a lower encapsulant thickness, and the upper encapsulant thickness is greater than the lower encapsulant thickness.

8. The light emitting module of any one of the preceding claims, wherein the first surface is a curved convex surface and the second surface is a curved convex surface.

9. The light emitting module of any one of the preceding claims, wherein the first surface is a curved convex surface and the second surface is a planar surface.

10. The light emitting module of any one of the preceding claims, wherein the LED is HV LED, DC LED or AC LED.

11. The light emitting module of any one of claims 7-10, wherein the electrode substrate (200) comprises apertures for light transmission.
